# EUROPEAN PATENT SPECIFICATION

(11) **EP 2 852 971 B1**
(45) Date of publication and mention of the grant of the patent: **15.01.2020**
(21) Application number: 13793615.9
(22) Date of filing: 25.04.2013
(51) Int. Cl.: H01L 21/768, H01L 23/31, H01L 23/48

(54) **SEMICONDUCTOR CONSTRUCTIONS AND METHODS OF FORMING SEMICONDUCTOR CONSTRUCTIONS**
HALBLEITERKONSTRUKTIONEN UND VERFAHREN ZUR BILDUNG VON HALBLEITERKONSTRUKTIONEN
CONSTRUCTIONS À SEMI-CONDUCTEURS ET PROCÉDÉS DE FORMATION DE CONSTRUCTIONS À SEMI-CONDUCTEURS

(30) Priority: 22.05.2012 US 201213478010
(43) Date of publication of application: 01.04.2015
(73) Proprietor: Micron Technology, Inc., Boise, ID 83716 (US)
(72) Inventor: SUN, Yangyang, San Diego, CA 92126 (US); PARKER, Randall, S., Boise, ID 83709 (US); GANDHI, Jaspreet, S., Boise, ID 83716 (US); LI, Jin, San Jose, CA 95129 (US)
(74) Representative: Somervell, Thomas Richard
(86) International application number: PCT/US2013/038128
(87) International publication number: WO 2013/176824

(56) References cited:
- KR-A- 20110 064 470
- US-A1- 2007 045 836
- US-A1- 2007 059 846
- US-A1- 2009 032 960
- US-A1- 2010 032 808
- US-A1- 2010 096 738
- US-A1- 2010 213 610
- US-A1- 2011 156 268
- US-A1- 2011 241 217
- US-A1- 2012 013 004
- US-A1- 2012 056 315
- US-A1- 2012 086 122

## Description

### TECHNICAL FIELD

Semiconductor constructions and methods of forming semiconductor constructions.

### BACKGROUND

Commercial production of integrated circuit devices, such as memory dice, may involve fabrication of a large number of identical circuit patterns on a single semiconductor wafer or other bulk semiconductor substrate. It is a continuing goal of semiconductor manufacturers to increase the density of semiconductor devices fabricated on a given size of semiconductor substrate to achieve increased yield of semiconductor devices and enhanced performance thereof.

One method for increasing the density of semiconductor devices in a semiconductor assembly is to create vias (i.e., through-holes) that extend entirely through a semiconductor die; and specifically that extend from an active surface of the die to the opposing backside surface of the die. The vias may be filled with electrically conductive material to form through-substrate interconnects (which may also be referred to as through-wafer interconnects). The interconnects provide electrical pathways from the active surface of the die to the backside surface of the die. The through-substrate interconnects may be electrically coupled to electrical contacts that are along the backside of the die, and that extend to circuit components external of the die. In some applications, the die may be incorporated into a three-dimensional multichip module (3-D MCM), and the circuit components external of the die may be comprised by another semiconductor die and/or by a carrier substrate.

Various methods for forming through-substrate interconnects in semiconductor substrates have been disclosed. For instance, U.S. Patent Nos. 7,855,140, 7,626,269 and 6,943,106 describe example methods that may be utilized to form through-substrate interconnects.

Various problems may be encountered during formation of connections to through-substrate interconnects. It is therefore desired to develop new methods of forming connections to through-substrate interconnects, and to develop new through-substrate interconnect architectures.

US2012/086122 relates to a semiconductor device having a conductive element disposed on a protruded conductive via and liner and covering a sidewall of the liner. The conductive element can protect the protruded conductive via and liner from being damaged. Further, the size of the conductive element is large, thus it is easy to perfom a probe test process.

US2010/0096738 relates to a method of forming integrated circuit die configured for attachment to another die or a package substrate. At least one due has a top and bottom surface and at least one through substrate including a tip protruding through a bottom surface. The tip has an outer dielectric tip liner.

US2009/0032960 relates to semiconductor devices and methods of manufacturing semiconductor devices including forming a conductive feature extending through a semiconductor substrate and forming a dielectric layer over the surface of the substrate.

US2012/0013004 relates to a semiconductor device including a substrate and via extending through the substrate. A first insulating layer is disposed on sidewalls of the via.

US2007/045836 and US2012/056315 relate to semiconductor devices having vias.

### BRIEF DESCRIPTION OF THE DRAWINGS

FIGS. 1-7 are diagrammatic cross-sectional views of a portion of a construction at various process stages of an example method.
FIGS. 3A, 5A and 7A are top views of the constructions of FIGS. 3, 5 and 7, respectively; with the views of FIGS. 3, 5 and 7 being along the lines 3-3 of FIG. 3A, 5-5 of FIG. 5A, and 7-7 of FIG. 7A, respectively.
FIGS. 8-10 are diagrammatic cross-sectional views of a portion of a construction at various process stages of another example method.
FIG. 10A is a top view of the construction of FIG. 10; with the view of FIG. 10 being along the line 10-10 of FIG. 10A.
FIG. 11 is diagrammatic cross-sectional view of a portion of a construction at a process stage alternative to that of FIG. 3 in accordance with another example.
FIG. 12 is diagrammatic cross-sectional view of a portion of a construction at a process stage subsequent to that of FIG. 11 in accordance with an example.

### DETAILED DESCRIPTION OF THE ILLUSTRATED EMBODIMENTS

According to the present invention there is provided a semiconductor construction and method of forming a semiconductor construction as set out in the claims. In some embodiments, the invention includes methods in which photosensitive material is provided over electrically conductive posts (which form part of through-wafer interconnects), and then the photosensitive material is patterned to form openings over the posts. Subsequently, under bump metallurgy (UBM) may be formed within the openings and over the photosensitive material. The photosensitive material may remain in finished constructions as insulative material under conductive materials of the UBM. There are included constructions comprising photosensitive material adjacent electrically conductive posts, and comprising electrically conductive caps that are over the posts and that extend to over the photosensitive material.

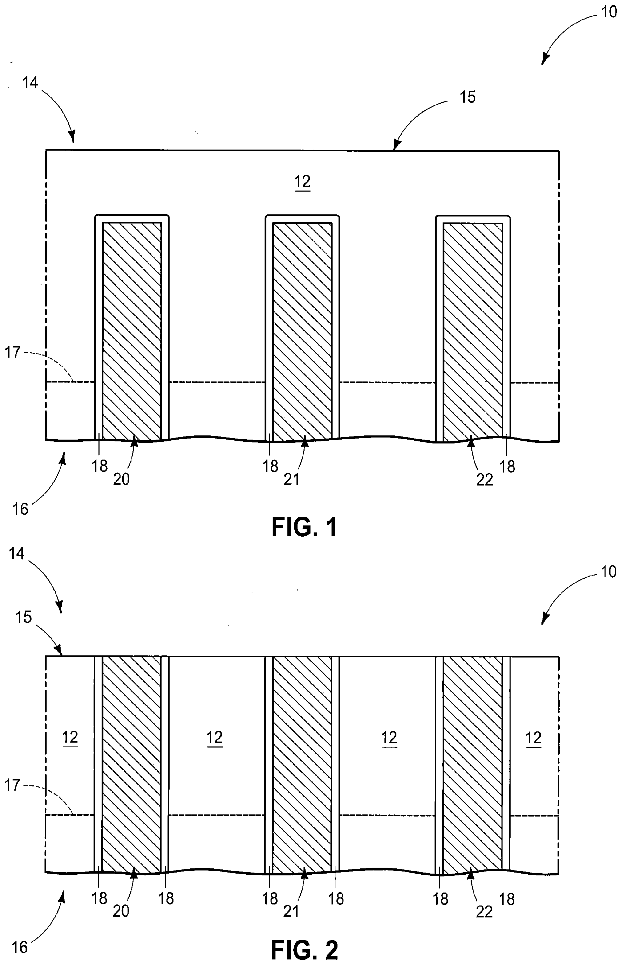

Examples are described with reference to FIGS. 1-12.

Referring to FIG. 1, a semiconductor construction 10 is shown to comprise a plurality of electrically conductive posts 20-22 which extend into a semiconductor base 12. In some embodiments, the base 12 may correspond to a semiconductor die. Such die has a backside 14 and a frontside 16. Integrated circuitry (not shown) may be associated with the frontside, and a dashed line 17 is provided to diagrammatically illustrate an approximate boundary of the circuitry within the die. The integrated circuitry may comprise memory (for instance, NAND, DRAM, etc.), logic, etc. Although the integrated circuitry may be predominantly associated with the frontside, in some embodiments there may also be integrated circuitry associated with the backside.

The backside has a surface 15, and such backside surface is above the posts at the processing stage of FIG. 1. The base would also have a frontside surface, and in some embodiments the posts 20-22 may pass entirely through the die so that the posts have surfaces along the frontside surface of the die. The frontside surface is not illustrated in FIG. 1. The frontside surface of the die may be joined to a carrier wafer (not shown) at the processing stage of FIG. 1.

Base 12 may comprise monocrystalline silicon, and may be referred to as a semiconductor substrate, or as a portion of a semiconductor substrate. The terms "semiconductive substrate," "semiconductor construction" and "semiconductor substrate" mean any construction comprising semiconductive material, including, but not limited to, bulk semiconductive materials such as a semiconductive wafer (either alone or in assemblies comprising other materials), and semiconductive material layers (either alone or in assemblies comprising other materials). The term "substrate" refers to any supporting structure, including, but not limited to, the semiconductive substrates described above.

The electrically conductive posts 20-22 may comprise any suitable electrically conductive compositions or combinations of compositions. In some embodiments, the posts may comprise one or more electrically conductive compositions formed within through-substrate vias (TSVs). In some embodiments, the posts may comprise copper.

Dielectric material 18 extends around posts 20-22, and electrically insulates the posts from base 12. The dielectric material may comprise any suitable composition or combination of compositions; including, for example, silicon dioxide, silicon nitride, etc. In some embodiments, the posts may comprise copper, and copper-barrier material (for instance, ruthenium-containing material) may be between the copper of the posts and the dielectric material 18.

Referring to FIG. 2, the construction 10 is subjected to grinding and/or other appropriate processing to form the backside surface 15 into a planarized surface extending across posts 20-22 and base 12.

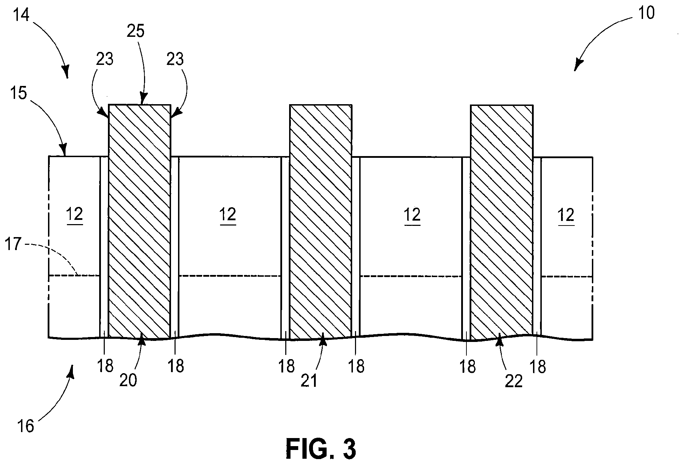

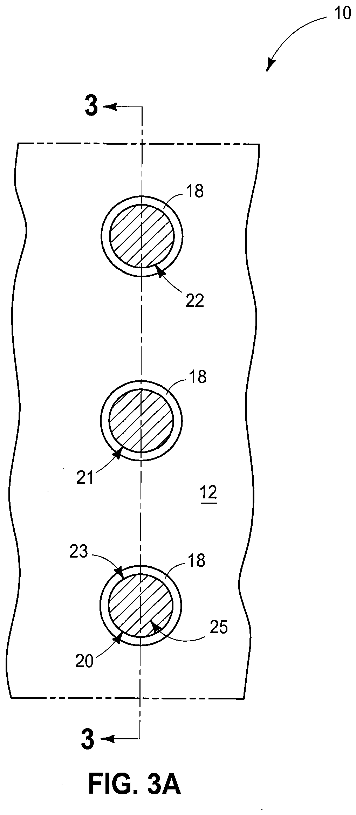

Referring to FIG. 3, the semiconductor material 12 is subjected to a relief etch which recesses the backside surface 15 relative to posts 20-22. For instance, if the semiconductor material 12 comprises, consists essentially of, or consist of silicon along the backside 14, the relief etch may be conducted utilizing fluorocarbon and/or oxidant.

The posts 20-22 of FIG. 3 have top surfaces above backside surface 15, and have sidewall surfaces extending from the top surfaces to the backside surface 15. For instance, conductive post 20 is shown to comprise a top surface 25, and to comprise sidewall surfaces 23 extending from the top surface 25 to the backside surface 15 of base 12.

The posts 20-22 may have any suitable configuration. For instance, FIG. 3A shows a top view of FIG. 3, and shows that the posts may be cylindrical columns in some embodiments. The top view of FIG. 3A also shows that the sidewalls 23 of FIG. 3 may be part of a continuous sidewall that extends entirely around the post 20.

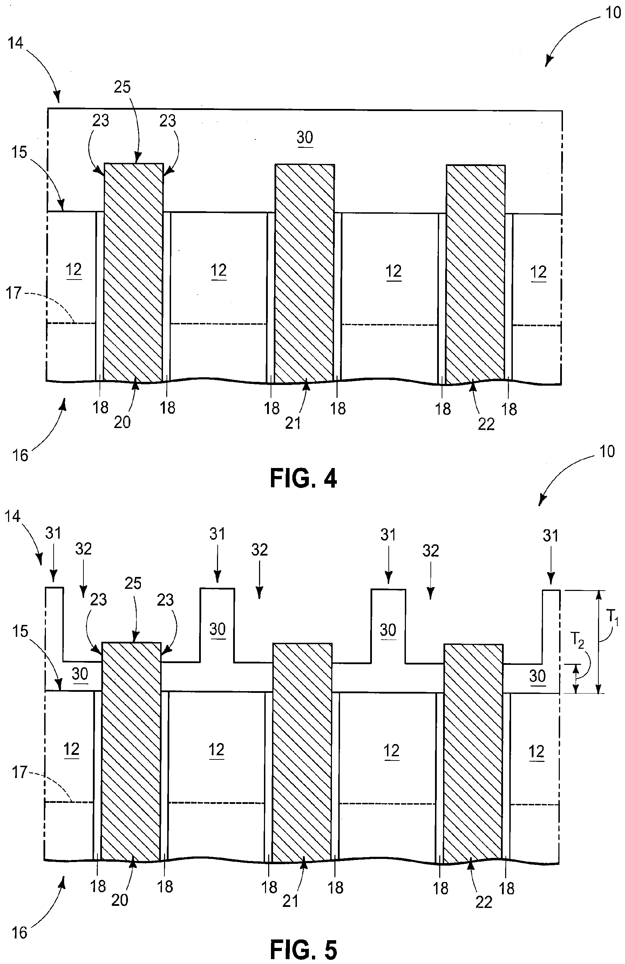

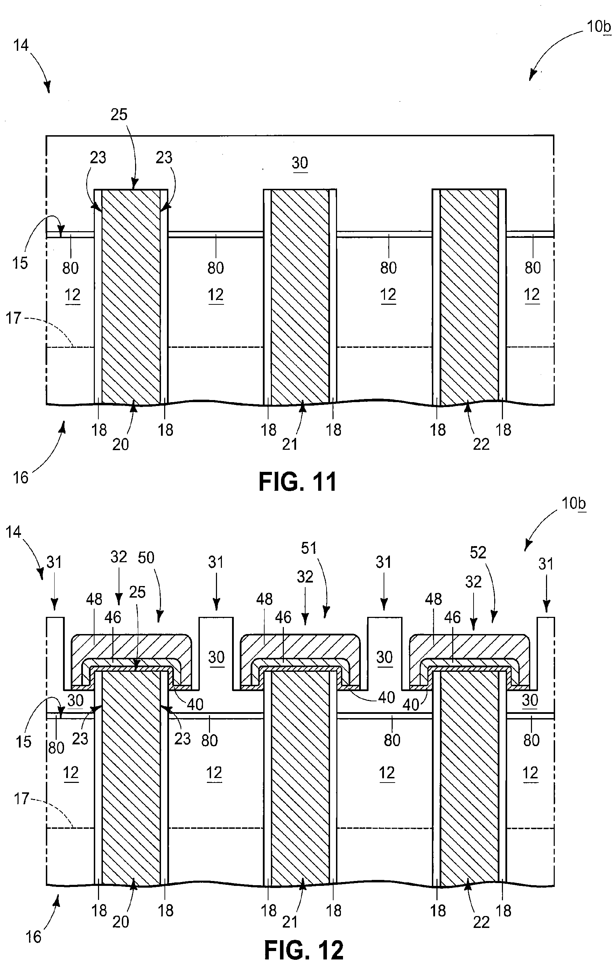

Referring to FIG. 4, a photosensitive material 30 is formed over the backside surface 15 of die 12, and over the posts 20-22. In the shown embodiment, the photosensitive material 30 directly contacts semiconductor material of die 12, and directly contacts the electrically conductive material of posts 20-22 along the tops of the posts (for instance, the top 25 of post 20), and along the sidewalls of the posts (for instance, the sidewalls 23 of post 20). If the posts comprise copper, the photosensitive material 30 may directly contact copper along the tops and sidewalls of the posts in some embodiments. In other examples, the photosensitive material may be spaced from the copper along the sidewalls of the posts by copper barrier material (for instance, ruthenium-containing material). In some examples, dielectric material (discussed below with reference to FIG. 11 as a material 80) may be provided across backside surface 15 prior to forming photosensitive material 30, and thus the photosensitive material may be spaced from the backside surface of die 12 by dielectric material.

The photosensitive material 30 may comprise any suitable composition, and preferably comprises a dielectric composition suitable for remaining in a finished construction. In some examples, the photosensitive material comprises one or more materials selected from the group consisting of siloxane-containing materials, epoxy acrylate-containing materials, polyimide-containing materials, and poly(benzoxazole)-containing materials.

The photosensitive material may be a photo-imageable spin-on dielectric in some embodiments. Also, the photosensitive material may be a material which can be deposited at a temperature of less or equal to about 200°C. Utilization of low temperature for deposition of the photosensitive material may be advantageous, as bonding adhesives utilized to attach the die to a carrier wafer may be configured to release the die upon exposure to temperatures in excess of about 200°C.

The utilization of photosensitive material 30 advantageously provides a material which is readily patterned by subsequent exposure to electromagnetic radiation, and yet which can remain in a finished semiconductor construction as a dielectric material. For purposes of interpreting this disclosure and the claims that follow, a "photosensitive material" is a material which changes upon exposure to electromagnetic radiation so that exposed regions may be selectively removed relative to unexposed regions, or vice versa. The selective removal of the exposed regions relative to the unexposed regions, or vice versa, may be conducted utilizing a developer solution.

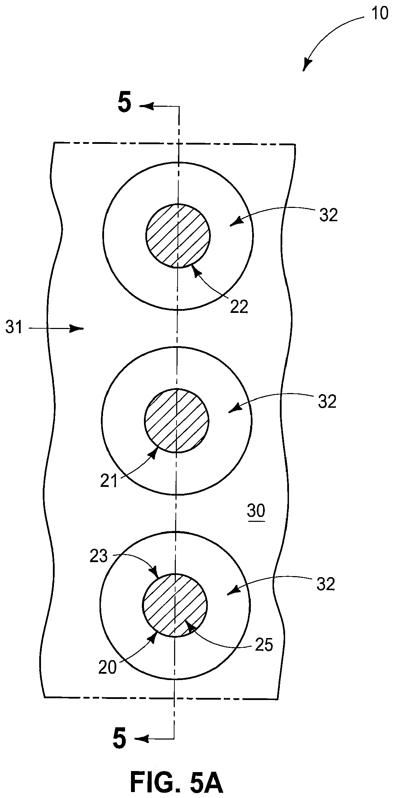

Referring to FIGS. 5 and 5A, the photosensitive material 30 is photo-patterned. Such photo-patterning may comprise conventional methodology of exposing the photosensitive material to patterned electromagnetic radiation, and then utilizing developer to selectively remove the exposed regions relative to the unexposed regions, or vice versa. The photo-patterning of the photosensitive material exposes the upper surfaces of the posts 20-22 (for instance, exposes upper surface 25 of post 20), and leaves regions of the photosensitive material 30 between the posts. In the shown embodiment, the photosensitive material 30 is patterned to form recessed regions 32 around each of the posts, with such recessed regions exposing sidewalls of the posts (for instance, the sidewalls 23 of post 20) in addition to exposing the top surfaces of the posts. In some examples, the recessed regions 32 may be considered to be thin regions, and the photo-patterned material 30 of FIG. 5 may be considered to comprise thick regions 31 extending between such thin regions. The thick regions have a thickness T₁ and the thin regions have a thickness T₂. In the shown embodiment, the upper surfaces of posts 20-22 (for instance, upper surface 25 of post 20) are above the photosensitive material 30 of the thin regions 32. The thickness T₂ may be less than or equal to about half of the thickness T₁ in some embodiments.

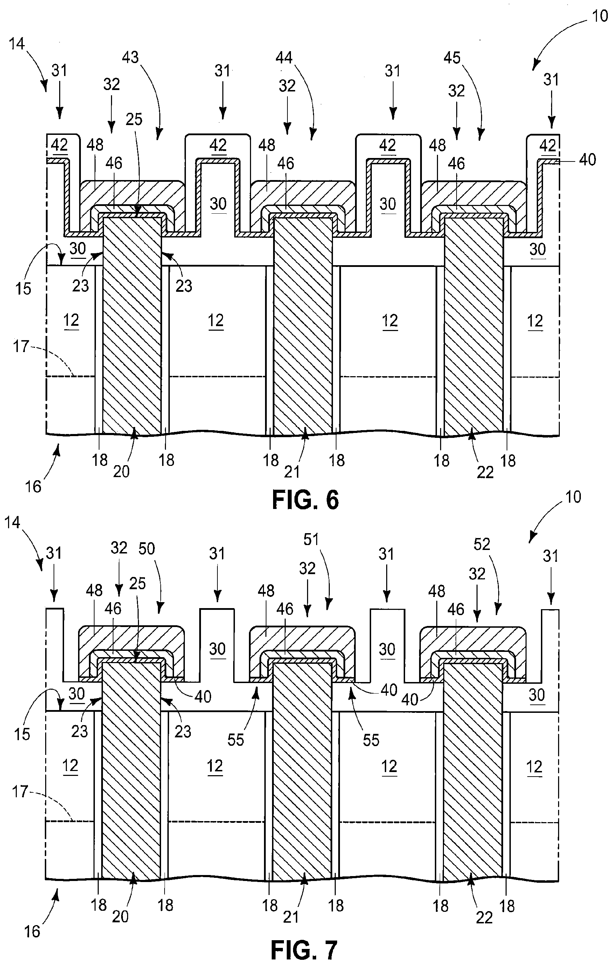

Referring to FIG. 6, electrically conductive material 40 is formed across material 30 and posts 20-22. In the shown embodiment, the electrically conductive material 40 is directly against the top surfaces of posts 20-22 (for instance, the top surface 25 of post 20), and also directly against the sidewall surfaces of such posts (for instance, the sidewall surfaces 23 of post 20). The electrically conductive material 40 is also directly against upper surfaces of photosensitive material 30. In some examples, the posts 20-22 may comprise copper, and copper barrier material (for instance, ruthenium-containing material) may be along the sidewalls of the posts. In such embodiments, the conductive material 40 may be along the copper barrier material adjacent the sidewalls of the posts, rather than directly against copper of the posts.

In some examples, the electrically conductive material 40 may be utilized as a seed material for subsequent electrolytic growth of copper. In such embodiments, the material 40 may, for example, comprise, consist essentially of, or consist of a mixture of titanium and copper.

A patterned masking material 42 is formed over the electrically conductive material 40. In some embodiments, the patterned masking material 42 may comprise photolithographically-patterned photoresist. The patterned masking material 42 has openings 43-45 extending therethrough. The openings are directly over posts 20-22, and directly over portions of the thin regions 32 of photosensitive material 30.

Electrically conductive materials 46 and 48 are formed within openings 43-45. In some examples, material 46 may comprise copper electrolytically grown over the conductive material 40, and material 48 may comprise nickel or palladium electrolytically grown over the material 46. Although two materials 46 and 48 are formed within openings 43-45 in the shown embodiment, in other embodiments a single conductive material may be formed within the openings, or more than two materials may be formed within such openings. For instance, both of nickel and palladium may be formed over the copper-containing material 46 in some embodiments. The materials 46 and 48 may be ultimately incorporated into under bump metallurgy (UBM), and thus may comprise conventional compositions suitable for utilization in UBM in some examples.

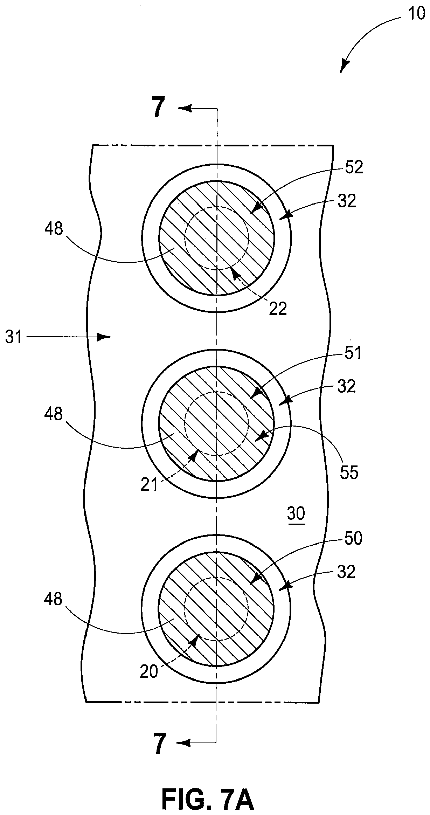

Referring to FIGS. 7 and 7A, masking material 42 (FIG. 6) is removed, and subsequently material 48 is utilized as a hard mask during etching of material 40. The construction of FIGS. 7 and 7A may be considered to comprise a plurality of electrically conductive caps 50-52 which are formed of material 40 in combination with the materials 46 and 48. The caps 50-52 are in one-to-one correspondence with the posts 20-22, and may ultimately correspond to UBM utilized for electrically coupling solder balls or other wiring components (not shown) with the posts.

The caps 50-52 may have any suitable shapes, and FIG. 7A shows an example in which the caps are circular. The posts 20-22 are shown in dashed-line in FIG. 7A to indicate that such posts are beneath caps 50-52.

FIG. 7 shows the electrically conductive material of caps 50-52 being directly against upper surfaces of post 20-22, and also along sidewall surfaces of the posts. Specifically, the conductive material 40 of the caps is directly against the upper surfaces and sidewall surfaces of the posts in the shown example. FIG. 7 also shows that the caps have edges that extend laterally outwardly beyond the posts and encircle the posts (for instance, cap 51 is shown to have an edge 55 that is laterally outward of post 21 and surrounds the post). Such edges of the caps are entirely directly over photosensitive material 30 in the shown example. The regions of the photosensitive material 30 that are directly under the edges of the caps have upper surfaces below the upper surfaces of posts 20-22 in the shown example.

The edges of the caps 50-52 cover portions of the thin regions 32 of photosensitive material 30 in the shown example, and leave other portions of the thin regions 32 uncovered (i.e., some portions of second thickness regions 32 extend outwardly beyond the edges of caps 50-52). In the shown example, an entirety of the edge of the electrically conductive material of a cap (for instance, the edge 55 of cap 51) is directly against photosensitive material 30. In other examples (not shown) dielectric material (for instance, silicon dioxide or silicon nitride) may be provided between the conductive material of cap and the photosensitive material 30.

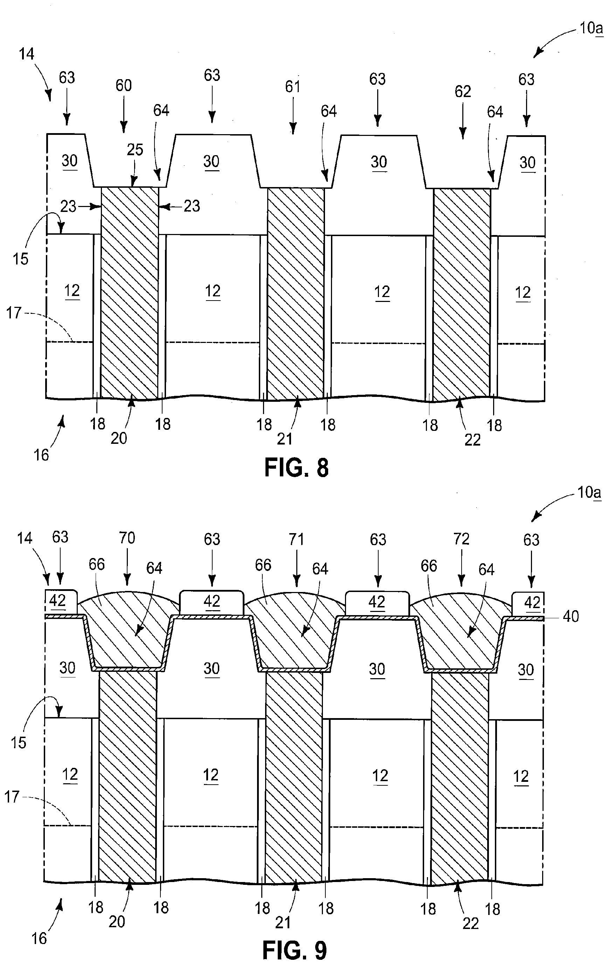

FIGS. 8-10 illustrate another example method of incorporating photosensitive material into a process of forming electrically conductive caps which are over and electrically coupled with conductive posts. FIG. 8 shows a construction 10a at a processing stage which may follow that of FIG. 4 in some examples.

The construction 10a of FIG. 8 comprises the photosensitive material 30 across the backside surface 15 of die 12. The material is patterned to form a plurality of openings 60-62 extending through the material to upper surfaces of the posts 20-22. The patterned material 30 has thin regions 64 adjacent posts 20-22, and has thick regions 63 between the thin regions. In the shown example, the thin regions have upper surfaces which are approximately coplanar with upper surfaces of posts 20-22. In some examples, some the thin regions may have surfaces which are above or below the upper surfaces of the adjacent posts so that only some of the thin regions have surfaces that are approximately coplanar with upper surfaces of adjacent posts.

Although the openings 60-62 are wider than the posts 20-22 in the shown example, in other examples the openings may be a comparable to the widths of the posts, and in yet other examples the openings may be narrower than the posts so that only portions of the upper surfaces of the posts are exposed.

Referring to FIG. 9, electrically conductive material 40 is formed across material 30 and posts 20-22. In the shown example, the electrically conductive material 40 is directly against the top surfaces of posts 20-22, and directly against upper surfaces of photosensitive material 30.

The patterned masking material 42 is formed over the electrically conductive material 40. The patterned masking material has openings 70-72 extending therethrough. The openings are directly over posts 20-22, and directly over portions of photosensitive material 30 adjacent the posts.

Electrically conductive material 66 is formed within openings 70-72. In some examples, material 66 may comprise the materials 46 and 48 described above with reference to FIG. 6, and may be ultimately incorporated into under bump metallurgy (UBM).

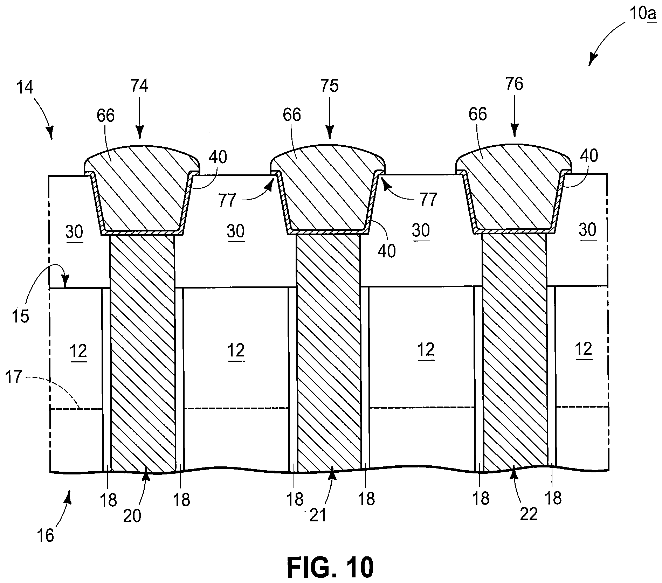

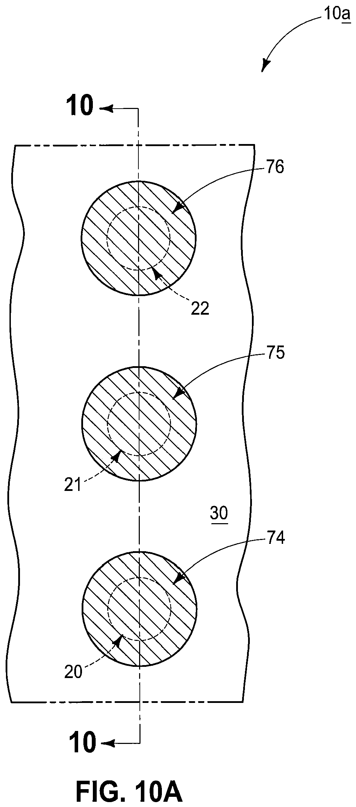

Referring to FIGS. 10 and 10A, masking material 42 (FIG. 9) is removed, and subsequently material 66 is utilized as a hard mask during etching of material 40. The construction of FIGS. 10 and 10A may be considered to comprise a plurality of electrically conductive caps 74-76 formed of material 40 in combination with material 66. The caps 74-76 are in one-to-one correspondence with the posts 20-22, and may ultimately correspond to UBM utilized for electrically coupling solder balls or other wiring components (not shown) with the posts.

The caps 74-76 may have any suitable shapes, and FIG. 10A shows an example in which the caps are circular. The posts 20-22 are shown in dashed-line in FIG. 10A to indicate that such posts are beneath caps 74-76.

FIG. 10 shows the electrically conductive material of caps 74-76 being directly against upper surfaces of post 20-22, and also shows that the caps have edges that extend laterally outwardly beyond the posts and encircle the posts (for instance, cap 75 is shown to have an edge 77 that is laterally outward of post 21 and surrounds the post). Such edges of the caps are entirely directly over photosensitive material 30 in the shown example. The regions of the photosensitive material 30 that are directly under the edges of the caps have upper surfaces above the upper surfaces of posts 20-22 in the shown example.

FIGS. 11 and 12 illustrate another example method of incorporating photosensitive material into a process of forming electrically conductive caps which are over and electrically coupled with conductive posts. FIG. 11 shows a construction 10b at a processing stage which may be alternative to that described above with reference to FIG. 4. Material 30 is formed over the backside surface 15 of die 12. However, material 30 is spaced from the backside surface of die 12 by a dielectric material 80, rather than being directly against such backside surface. The dielectric material 80 may comprise any suitable material, and may, for example, comprise, consist essentially of, or consist of second nitride, silicon oxide, etc. The dielectric material 80 may be utilized to provide additional protection and/or electrical insulation over the semiconductor material of die 12 beyond that provided by the photosensitive material 30 alone.

The example of FIG. 11 also differs from that of FIG. 4 in that the dielectric material 18 is shown extending along the sidewall surfaces of posts 20-22 above the backside surface 15 of die 12 (for instance, the dielectric material 18 is shown extending along the sidewall surfaces 23 of post 20). Although it is a dielectric 18 shown along the sidewalls of the posts above backside 15 in the example of FIG. 11, there may be additionally, or alternately, conductive materials along such sidewalls of posts in other examples. For instance, if the posts comprise copper, there may be copper barrier material (for instance, ruthenium-containing material) along the sidewalls of the posts above the backside surface 15.

Referring to FIG. 12, the construction 10b is shown at a processing stage analogous to that described above with reference to FIG. 7. Accordingly, material 30 has been patterned into thick regions 31 and thin regions 32, and electrically conductive caps have been formed over the thin regions and directly against upper surfaces of posts 20-22. The caps comprise electrically conductive materials 40, 46 and 48, and may correspond to UBM metallurgy. The construction of FIG. 12 is similar to that described above with reference to FIG. 7. The construction differs from that of FIG. 7 in that the dielectric material 80 is between photosensitive material 30 and die 12. The construction also differs from that of FIG. 7 in that conductive material 40 is not directly against the sidewall surfaces of posts 20-22 (for instance, the sidewall surfaces 23 of post 20), but rather is spaced from such sidewall surfaces by material 18.

Some of the examples described herein may be advantageously relatively simple to incorporate into existing fabrication processes as compared to prior art methods, in that such examples may utilize tools which already exist in semiconductor fabrication facilities, such as photo-processing tools, etc. In some examples, the photosensitive material 30 described above may be a photo-imageable spin-on dielectric. Such materials can have photosensitive resolution of less or equal to 1 micrometer, and can have sufficient thermal resistance to tolerate high-temperature stacking procedures that may be utilized during a die packaging process. Some examples may enable reduced through thickness variation (TTV) across a wafer relative to prior art processes.

The particular orientation of the various examples in the drawings is for illustrative purposes only, and the examples may be rotated relative to the shown orientations in some applications. The description provided herein, and the claims that follow, pertain to any structures that have the described relationships between various features, regardless of whether the structures are in the particular orientation of the drawings, or are rotated relative to such orientation.

The cross-sectional views of the accompanying illustrations only show features within the planes of the cross-sections, and do not show materials behind the planes of the cross-sections in order to simplify the drawings.

When a structure is referred to above as being "on" or "against" another structure, it can be directly on the other structure or intervening structures may also be present. In contrast, when a structure is referred to as being "directly on" or "directly against" another structure, there are no intervening structures present. When a structure is referred to as being "connected" or "coupled" to another structure, it can be directly connected or coupled to the other structure, or intervening structures may be present. In contrast, when a structure is referred to as being "directly connected" or "directly coupled" to another structure, there are no intervening structures present.

In some examples, a semiconductor construction comprises an electrically conductive post extending through a semiconductor die. The post has an upper surface above a backside surface of the die, and has a sidewall surface extending between the backside surface and the upper surface. A photosensitive material is over the backside surface and along the sidewall surface. Electrically conductive material is directly against the upper surface of the post. The electrically conductive material is configured as a cap over the post. The cap has an edge that extends laterally outwardly beyond the post and encircles the post. An entirety of the edge is directly over the photosensitive material.

In some examples, a semiconductor construction comprises a plurality of electrically conductive posts extending through a semiconductor die. The posts have upper surfaces above a backside surface of the die, and have sidewall surfaces extending between the backside surface and the upper surfaces. A photosensitive material is over the backside surface and along the sidewall surfaces. Electrically conductive material caps are directly against the upper surfaces of the posts and directly over regions of the photosensitive material adjacent the posts. The photosensitive material has a first thickness in regions between the caps and has a second thickness in regions directly under the caps. The second thickness is less than the first thickness. Upper surfaces of the second thickness regions are below the upper surfaces of the posts.

In some examples, a semiconductor construction comprises a plurality of electrically conductive posts extending through a semiconductor die. The posts have upper surfaces above a backside surface of the die, and have sidewall surfaces extending between the backside surface and the upper surfaces. A photosensitive material is over the backside surface and along the sidewall surfaces. Electrically conductive material caps are directly against the upper surfaces of the posts and directly over regions of the photosensitive material adjacent the posts. The photosensitive material has a first thickness in regions between the posts and has a second thickness in regions adjacent the posts. The second thickness is less than the first thickness. Upper surfaces of the first thickness regions are above the upper surfaces of the posts.

In some examples, a method of forming a semiconductor construction comprises forming a photosensitive material across a plurality of through-wafer interconnects, and photo-patterning the photosensitive material to expose upper surfaces of the interconnects while leaving regions of the photosensitive material between the interconnects. The method also comprises forming electrically conductive material directly against the exposed upper surfaces of the interconnects and directly against the photosensitive material. The electrically conductive material forms caps over the interconnects, with the caps having edges that extend laterally outwardly beyond the interconnects and that encircle the interconnects. The edges are entirely directly over the photosensitive material.

## Claims

1. A semiconductor construction comprising:
an electrically conductive post (20 - 22) extending through a semiconductor die (12); the post (20 - 22) comprising an electrically conductive material having an upper surface above a backside surface (15) of the die (12), and having a sidewall surface (23) extending between the backside surface (15) and the upper surface;
a photosensitive material (30) over and in physical contact with the backside surface (15); the photosensitive material (30) having an opening (32) encircling the conductive post (20 - 22) with a portion of the photosensitive material (30) remaining below the opening being in direct contact with the electrically conductive material along the electrically conductive sidewall surface (23);
a first electrically conductive material (40) directly against the electrically conductive upper surface and a portion of the sidewall of the post (20 - 22); the first electrically conductive material (40) being configured as a cap over the post; the cap having an edge that extends laterally outwardly beyond the post (20 - 22) and encircles the post (20 - 22) within the opening; an entirety of the edge being directly over the photosensitive material (30);
a second electrically conductive material (46) over the first electrically conductive material (40) and extending within the opening ; and
a third electrically conductive material (48) over the second electrically conductive material (46) and extending into the opening.

2. The semiconductor construction of claim 1 wherein the post (20 - 22) comprises copper.

3. A method of forming a semiconductor construction, comprising:
forming a photosensitive material (30) across a plurality of through-wafer interconnects, the photosensitive material (30) being in direct contact with conductive material along sidewalls (23) of the interconnects;
photo-patterning the photosensitive material (30) to expose upper surfaces of the interconnects while leaving regions of the photosensitive material (30) between the interconnects;
forming openings (32) partially through the photosensitive material, the openings surrounding an upper portion of the interconnects and exposing the sidewalls (23) along the upper portion of the interconnects;
forming a first electrically conductive material (40) directly against the exposed upper surfaces and exposed sidewalls surfaces (23) of the interconnects and directly against the photosensitive material (30); the first electrically conductive material (40) forming caps over the interconnects, with the caps having edges that extend laterally outwardly beyond the interconnects and encircle the interconnects; the edges being entirely directly over the photosensitive material (30) and within the openings; and
forming a second electrically conductive material (46) over the first electrically conductive material (40) and extending into the openings.

## Patentansprüche

1. Halbleiterkonstruktion, umfassend:
einen elektrisch leitfähigen Stift (20-22), welcher sich durch einen Halbleiterchip (12) erstreckt; wobei der Stift (20-22) ein elektrisch leitfähiges Material umfasst, welches eine obere Fläche oberhalb einer Rückseitenfläche (15) des Chips (12) aufweist, und welches eine Seitenwandfläche (23) aufweist, welche sich zwischen der Rückseitenfläche (15) und der oberen Fläche erstreckt;
ein lichtempfindliches Material (30) oberhalb und in physischem Kontakt mit der Rückseitenfläche (15); wobei das lichtempfindliche Material (30) eine Öffnung (32) aufweist, welche den leitfähigen Stift (20-22) umschließt, wobei ein Abschnitt des lichtempfindlichen Materials (30), welches unterhalb der Öffnung bleibt, in direktem Kontakt mit dem elektrisch leitfähigen Material entlang der elektrisch leitfähigen Seitenwandfläche (23) steht;
ein erstes elektrisch leitfähiges Material (40), direkt gegen die elektrische leitfähige obere Fläche und einen Abschnitt der Seitenwand des Stifts (20-22); wobei das erste elektrisch leifähige Material (40) als Kappe oberhalb des Stifts konfiguriert ist; wobei die Kappe einen Rand aufweist, welcher sich seitlich nach außen über den Stift (20-22) hinaus erstreckt und den Stift (20-22) innerhalb der Öffnung umschließt; wobei die Gesamtheit des Rands sich direkt oberhalb des lichtempfindlichen Materials (30) befindet;
ein zweites elektrisch leifähiges Material (46), welches sich oberhalb des ersten elektrisch leifähigen Materials (40) befindet und sich innerhalb der Öffnung erstreckt; und
ein drittes elektrisch leifähiges Material (48), welches sich oberhalb des zweiten elektrisch leifähigen Materials (46) befindet und sich in die Öffnung erstreckt.

2. Halbleiterkonstruktion nach Anspruch 1, wobei der Stift (20-22) Kupfer umfasst.

3. Verfahren zum Bilden einer Halbleiterkonstruktion, umfassend:
Bilden eines lichtempfindlichen Materials (30) über eine Mehrzahl von Waferdurchgangsverbindungen, wobei das lichtempfindliche Material (30) sich in direktem Kontakt mit leitfähigem Material entlang Seitenwänden (23) der Verbindungen befindet;
Photostrukturieren des lichtempfindlichen Materials (30), um obere Flächen der Verbindungen freizulegen, während zwischen den Verbindungen Bereiche des lichtempfindlichen Materials (30) hinterlassen werden;
Bilden von Öffnungen (32), welche teilweise das lichtempfindliche Material durchdringen, wobei die Öffnungen einen oberen Abschnitt der Verbindungen umschließen und die Seitenwände (23) entlang des oberen Abschnitts der Verbindungen freilegen;
Bilden eines ersten elektrisch leifähigen Materials (40) direkt gegen die freigelegten oberen Flächen und die freigelegten Seitenwandflächen (23) der Verbindungen und direkt gegen das lichtempfindliche Material (30); wobei das erste elektrisch leifähige Material (40) Kappen oberhalb der Verbindungen bildet, wobei die Kappen Ränder aufweisen, welche sich seitlich nach außen über die Verbindungen hinaus erstrecken und die Verbindungen umschließen; wobei die Ränder sich vollständig direkt oberhalb des lichtempfindlichen Materials (30) und innerhalb der Öffnungen befinden;
und
Bilden eines zweiten elektrisch leifähigen Materials (46) oberhalb des ersten elektrisch leifähigen Materials (40), welches sich in die Öffnungen erstreckt.

## Revendications

1. Construction à semiconducteurs comprenant :
une broche électriquement conductrice (20 - 22) qui s'étend au travers d'une puce semiconductrice (12) ; la broche (20 - 22) comprenant un matériau électriquement conducteur qui comporte une surface supérieure au-dessus d'une surface de côté arrière (15) de la puce (12), et comportant une surface de paroi latérale (23) qui s'étend entre la surface de côté arrière (15) et la surface supérieure ;
un matériau photosensible (30) au-dessus de la surface de côté arrière (15) et en contact physique avec cette même surface ; le matériau photosensible (30) comportant une ouverture (32) qui encercle la broche conductrice (20 - 22), une partie du matériau photosensible (30) qui reste au-dessous de l'ouverture étant en contact direct avec le matériau électriquement conducteur le long de la surface de paroi latérale électriquement conductrice (23) ;
un premier matériau électriquement conducteur (40) directement contre la surface supérieure électriquement conductrice et une partie de la paroi latérale de la broche (20 - 22) ; le premier matériau électriquement conducteur (40) étant configuré en tant que capuchon au-dessus de la broche ; le capuchon comportant un bord qui s'étend latéralement vers l'extérieur au-delà de la broche (20 - 22) et qui encercle la broche (20 - 22) à l'intérieur de l'ouverture ; la totalité du bord étant directement au-dessus du matériau photosensible (30) ;
un deuxième matériau électriquement conducteur (46) au-dessus du premier matériau électriquement conducteur (40) et s'étendant à l'intérieur de l'ouverture ; et
un troisième matériau électriquement conducteur (48) au-dessus du deuxième matériau électriquement conducteur (46) et s'étendant à l'intérieur de l'ouverture.

2. Construction à semiconducteurs selon la revendication 1, dans laquelle la broche (20 - 22) comprend du cuivre.

3. Procédé de formation d'une construction à semiconducteurs, comprenant :
la formation d'un matériau photosensible (30) au travers d'une pluralité d'interconnexions de plaquette traversante, le matériau photosensible (30) étant en contact direct avec le matériau conducteur le long de parois latérales (23) des interconnexions ;
la photo-conformation du matériau photosensible (30) de manière à exposer des surfaces supérieures des interconnexions tout en laissant des régions du matériau photosensible (30) entre les interconnexions ;
la formation d'ouvertures (32) partiellement au travers du matériau photosensible, les ouvertures entourant une partie supérieure des interconnexions et exposant les parois latérales (23) le long de la partie supérieure des interconnexions ;
la formation d'un premier matériau électriquement conducteur (40) directement contre les surfaces supérieures exposées et les surfaces de parois latérales exposées (23) des interconnexions et directement contre le matériau photosensible (30) ; le premier matériau électriquement conducteur (40) formant des capuchons au-dessus des interconnexions, les capuchons comportant des bords qui s'étendent latéralement vers l'extérieur au-delà des interconnexions et qui encerclent les interconnexions ; les bords étant en totalité directement au-dessus du matériau photosensible (30) et à l'intérieur des ouvertures ; et
la formation d'un deuxième matériau électriquement conducteur (46) au-dessus du premier matériau électriquement conducteur (40) et s'étendant à l'intérieur des ouvertures.
